(19)

Europäisches
Patentamt
European
Patent Office
Office européen
des brevets

(11) **EP 4 614 166 A1**

(12) **EUROPEAN PATENT APPLICATION**
published in accordance with Art. 153(4) EPC

(43) Date of publication:
**10.09.2025  Bulletin 2025/37**

(21) Application number: **23884208.2**

(22) Date of filing: **25.06.2023**

(51) International Patent Classification (IPC):
**G01R 31/36** (2020.01)

(52) Cooperative Patent Classification (CPC):
**G01R 31/36; G01R 31/367; G01R 31/385;
G01R 31/387; G01R 31/392; G01R 31/396**

(86) International application number:
**PCT/CN2023/102163**

(87) International publication number:
**WO 2024/093269 (10.05.2024 Gazette 2024/19)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **31.10.2022  CN 202211348958**

(71) Applicant: **BYD Company Limited
Shenzhen, Guangdong 518118 (CN)**

(72) Inventors:
• **QI, Tianyu
Shenzhen, Guangdong 518118 (CN)**

• **JIAO, Xinyan
Shenzhen, Guangdong 518118 (CN)**
• **LEI, Song
Shenzhen, Guangdong 518118 (CN)**
• **GUO, Jiawei
Shenzhen, Guangdong 518118 (CN)**
• **ZHANG, Wenqian
Shenzhen, Guangdong 518118 (CN)**

(74) Representative: **Mathys & Squire
The Shard
32 London Bridge Street
London SE1 9SG (GB)**

(54) **BATTERY STATE OF HEALTH PREDICTION METHOD, ELECTRONIC DEVICE, AND READABLE STORAGE MEDIUM**

(57)    A battery state of health prediction method, an electronic device, and a readable storage medium, relating to the technical field of batteries. The method comprises: according to a preset target working condition, acquiring a cycle time, a storage time, and an average temperature within a target time period of a target battery; determining a cycle capacity loss of the target battery according to the cycle time, the average temperature, and a first preset relationship; and determining a storage capacity loss of the target battery according to the storage time, the average temperature, and a second preset relationship; obtaining a cycle state of health standard deviation according to the cycle capacity loss and a third preset relationship; and obtaining a storage state of health standard deviation according to the storage capacity loss and a fourth preset relationship; and determining a predicted state of health of the target battery under the target working condition according to the cycle capacity loss, the storage capacity loss, the cycle state of health standard deviation, and the storage state of health standard deviation.

FIG. 2

**Description**

**CROSS-REFERENCE TO RELATED APPLICATIONS**

The present disclosure claims the benefit of priority to Chinese Patent Application No. 202211348958.0 filed on October 31, 2022, titled "BATTERY STATE OF HEALTH PREDICTION METHOD, ELECTRONIC DEVICE, AND READABLE STORAGE MEDIUM", which is incorporated herein in its entirety.

**FIELD**

Embodiments of the present disclosure relate to the technical field of batteries, specifically to a method for predicting a battery health state, an electronic device, and a computer-readable storage medium.

**BACKGROUND**

At present, a battery health state is generally evaluated in the following ways: firstly, a battery simulation model is configured to simulate the temperature changes of the battery at various positions inside the actual battery, and the battery capacity is obtained through screening and calculation to obtain the life of the actual battery at different positions; secondly, an attenuation basic model is established with reference to the existing battery usage data and life data, and the life data of the target battery is obtained through the attenuation basic model according to the usage data of the target battery; and thirdly, analysis of the correlation between calendar life capacity fade, AC internal resistance variations, DC internal resistance changes, and temperature/voltage in batteries, and the true life state of the cell is inferred from the accelerated aging test of the cell through fitting formula.

However, the first method mentioned above only considers the influence of the temperature field on the life of the cell, and ignores the inconsistent capacity attenuation of the cell itself caused by the factory manufacturing process. The second method is to build a model according to existing battery data, and there is no life assessment in principle. The assessment accuracy is unsatisfactory and it lacks broad applicability. The third method is mainly aimed at the life prediction of a single-cell accelerated test, and does not consider the influence of temperature field differences in the battery and cell consistency differences.

**SUMMARY**

An object of an embodiment of the present disclosure is to provide a new technical solution for evaluating a battery health state accurately.

According to a first aspect of the present disclosure, a method for predicting a battery health state is provided, the method includes:

cycle time, storage time, and average temperature during the target period of a target battery is obtained according to a preset target operating condition;

a cycle capacity loss of the target battery is determined according to the cycle time, the average temperature, and a first preset relationship; and a storage capacity loss of the target battery is determined according to the storage time, the average temperature, and a second preset relationship;

a standard deviation of the cycle health state is obtained according to the cycle capacity loss and a third preset relationship; and a standard deviation of the storage health state is obtained according to the storage capacity loss and a fourth preset relationship;

and a predicted health state of the target battery under the target operating condition is determined according to the cycle capacity loss, the storage capacity loss, the standard deviation of the cycle health state, and the standard deviation of the storage health state.

In an embodiment, the predicted health state of the target battery is determined according to the cycle capacity loss, the storage capacity loss, the standard deviation of the cycle health state, and the standard deviation of the storage health state, which includes:

a median value of the health state of a cell of the target battery under the target operating condition is obtained according to the cycle capacity loss and the storage capacity loss;

a distribution standard deviation of the health state of a cell of the target battery under the target operating condition is obtained according to the standard deviation of the cycle health state and the standard deviation of the storage health state;

and a predicted health state of the target battery is obtained according to the median value of the health state and the distribution standard deviation of the health state.

In an embodiment, the method further includes:

first health state data and second health state data is obtained, the first health state data is obtained by performing a charge/discharge cycle test of a first number of first cells at the corresponding cycle temperature, and the second health state data is obtained by performing a storage test of a second number of second cells at the corresponding storage temperature; and the first health state data refers to the data indicating the health state of the first cell after performing a charge/discharge cycle test for the preset cycle time, and the second health state data refers to the data indicating the health state of the second cell after performing a storage test for the storage cycle time;

first median data of a first number of first cells is determined according to the first health state data, and second median data of a second number of second cells is determined according to the second health state data. The first median data refers to the data indicating an average value of the health state of the first number of first cells after performing a charge/discharge cycle test for the preset cycle time, and the second median data refers to the data indicating an average value of the health state of the second number of second cells after performing a storage test for the preset storage time.

The first preset relationship is obtained according to the cycle temperature and the first median data; and the second preset relationship is obtained according to the storage temperature and the second median data.

In an embodiment, the method further includes:

a first expression representing the corresponding relationship between the health state and the cycle time of the first cell is obtained according to the first health state data; and a second expression representing the corresponding relationship between the health state and the storage time of the second cell is obtained according to the second health state data;

reference cycle time corresponding to a plurality of preset health states is determined according to the first preset relationship, and reference storage time corresponding to a plurality of preset health states is determined according to the second preset relationship;

a first reference health state corresponding to the first cell is obtained according to the reference cycle time and the first expression; and a second reference health state corresponding to the second cell is obtained according to the reference storage time and the second expression;

a third preset relationship is obtained according to the first reference health state, and a fourth preset relationship is obtained according to the second reference health state.

In an embodiment, the third preset relationship is obtained according to the first reference health state, and the fourth preset relationship is obtained according to the second reference health state, which includes:

a first standard deviation of a first reference health state corresponding to each of the preset health states at each of the cycle temperature is determined; and a second standard deviation of a second reference health state corresponding to each of the preset health states at each of the storage temperature is determined;

and the third preset relationship is obtained according to the first standard deviation, and the fourth preset relationship is obtained according to the second standard deviation.

In an embodiment, the first preset relationship is:

$$Q1 = 1 - \left(c1 * T1^{d1} + e1\right) * t1^{f1}$$

wherein Q1 is the cycle capacity loss, T1 is the cycle temperature, t1 is the cycle time, and c1, d1, e1, f1 are the fitting coefficients;

the second preset relationship is:

$$Q2 = 1 - \left(c2 * T2^{d2} + e2\right) * t2^{f2}$$

wherein Q2 is the storage capacity loss, T2 is the storage temperature, t2 is the storage time, and c2, d2, e2 and f2 are the fitting coefficients.

In an embodiment, the third preset relationship is:

$$SD1 = A1 * \exp(SOH1^{B1} + C1) + D1$$

$$SOH1 = 1 - Q1$$

wherein SD1 is the standard deviation of the cycle health state, Q1 is the cycle capacity loss, and A1, B1, C1 and D1 are the fitting coefficients;
the fourth preset relationship is:

$$SD2 = A2 * \exp(SOH2^{B2} + C2) + D2$$

$$SOH2 = 1 - Q2$$

wherein SD2 is the standard deviation of the storage health state, Q2 is the storage capacity loss, and A2, B2, C2, and D2 are the fitting coefficients.

In an embodiment, average temperature during the target period of the target battery is obtained, which includes:

cell temperature of each of the cells contained in the target battery during the target period is obtained;
and the average value of the cell temperature is determined as the average temperature.

According to a second aspect of the present disclosure, an electronic device is also provided, the electronic device includes a memory and a processor, the memory is configured to store a computer program; and the processor is configured to execute the computer program to implement the method according to the first aspect of the present disclosure.
According to a third aspect of the present disclosure, a computer-readable storage medium is also provided, the computer-readable storage medium is configured to store a computer program thereon, and when executed by a processor, the computer program implements the method according to the first aspect of the present disclosure.
According to the embodiment, the cycle capacity loss and the storage capacity loss of the target battery are determined according to the cycle time, the storage time and the average temperature of the target battery, then a standard deviation of the cycle health state and a standard deviation of the storage health state of the target battery are obtained according to the cycle capacity loss and the storage capacity loss, and the predicted health state of the target battery is predicted according to the cycle capacity loss, the storage capacity loss, the standard deviation of the cycle health state and the standard deviation of the storage health state. In the embodiment, from the perspective of cells, the consistency deviation of cycle and storage caused by the process for manufacturing cells is fully considered, and the predicted health state of the target battery can be more accurately predicted, and the calculation cost is low.
Other features and advantages of embodiments of the present disclosure will become apparent from the following detailed description of exemplary embodiments of the present disclosure with reference to the accompanying drawings.

## BRIEF DESCRIPTION OF THE DRAWINGS

The accompanying drawings, which are incorporated in and constitute a part of the specification, illustrate embodiments of the present disclosure and, together with their description, serve to explain the principles of the embodiments of the present disclosure.

FIG. 1 is a schematic block diagram of a hardware configuration of an electronic device that can be configured to implement an embodiment of the present disclosure;
FIG. 2 is a schematic flow diagram of a method for predicting a battery health state according to one embodiment;
FIG. 3 is a schematic flow diagram of a method for predicting a battery health state according to another embodiment;
FIG. 4 is a block schematic diagram of an electronic device according to one embodiment.

## DETAILED DESCRIPTION

Various exemplary embodiments of the present disclosure will now be described in detail with reference to the drawings. It should be noted that the relative arrangements of components and steps, numerical expressions, and numerical values set forth in these examples do not limit the scope of the present invention unless specifically stated otherwise.

The following description of at least one exemplary embodiment is merely illustrative in practice and is in no way intended to limit the present invention and its application or use.

Techniques, methods, and apparatuses known to a person skill in the art can not be discussed in detail, but should be regarded as part of the specification where appropriate.

In all examples shown and discussed herein, any specific values should be construed as merely exemplary and not as limiting. Accordingly, other examples of exemplary embodiments can have different values.

It should be noted that like reference numerals and letters refer to like items in the following drawings, and therefore, once an item is defined in one drawing, it is not necessary to further discuss it in the following drawings.

< Hardware Configuration >

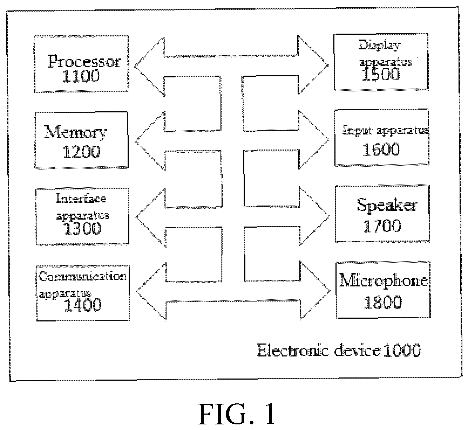

FIG. 1 is a schematic structural diagram of an electronic device that can be configured to implement an embodiment of the present disclosure.

The electronic device 1000 can be a smartphone, a portable computer, a desktop computer, a tablet computer, a server, or the like, and is not limited herein.

The electronic device 1000 can include, but is not limited to, a processor 1100, a memory 1200, an interface apparatus 1300, a communication apparatus 1400, a display apparatus 1500, an input apparatus 1600, a speaker 1700, a microphone 1800, and the like. The processor 1100 can be a central processing unit CPU, a graphics processor GPU, a microprocessor MCU, or the like, for executing a computer program, which can be written in an instruction set of architectures such as x86, Arm, RISC, MIPS, SSE, or the like. The memory 1200 includes, for example, a ROM (Read Only Memory), a RAM (Random Access Memory), a non-volatile memory such as a hard disk, and the like. The interface apparatus 1300 includes, for example, a USB interface, a serial interface, a parallel interface, and the like. The communication apparatus 1400 can perform wired communication using, for example, an optical fiber or a cable, or perform wireless communication, and the wireless communication specifically can include WiFi communication, Bluetooth communication, 2G/3G/4G/5G communication, or the like. The display apparatus 1500 is, for example, a liquid crystal display, a touch display, or the like. The input apparatus 1600 can include, for example, a touch screen, a keyboard, a somatosensory input, or the like. The speaker 1700 is configured to output an audio signal. The microphone 1800 is configured to collect audio signals.

As applied to the embodiment of the present disclosure, the memory 1200 of the electronic device 1000 is configured to store a computer program, and the computer program is configured to control the processor 1100 to operate to implement the method according to the embodiment of the present disclosure. A person skilled in the art can design the computer program according to the solutions disclosed in the present disclosure. How the computer program controls the processor to operate is well known in the art and is not described in detail herein. The electronic device 1000 can be equipped with an intelligent operating system (for example, a system such as Windows, Linux, Android, IOS, etc.) and application software.

A person skilled in the art will understand that although a plurality of apparatuses of the electronic device 1000 are illustrated in FIG. 1, the electronic device 1000 of the embodiment of the present disclosure can relate to only some of the apparatuses, for example, only the processor 1100, the memory 1200, and the like.

Hereinafter, various embodiments and examples according to the present invention will be described with reference to the accompanying drawings.

< Method Embodiment>

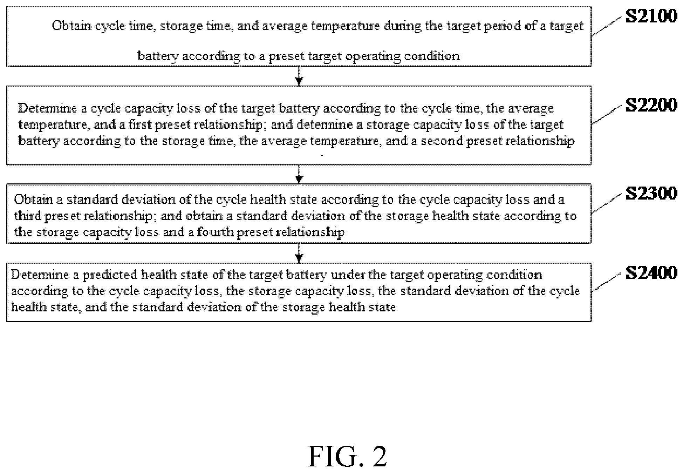

FIG. 2 is a schematic flow diagram of a method for predicting a battery health state according to one embodiment, which can be implemented by an electronic device. For example, the electronic device can be an electronic device 1000 as shown in FIG. 1.

As shown in FIG. 2, the method for predicting the battery health state of the embodiment can include steps S2100 to S2400 as follows:

in step S2100, cycle time, storage time, and average temperature during the target period of a target battery is obtained according to a preset target operating condition.

In the embodiment, the target operating condition can be disassembled to obtain the cycle time, storage time, and average temperature of the target battery.

The target period can be set in advance according to an application scenario or a specific requirement. For example, the target period can be within one day in the past.

The target battery of the embodiment can include at least one cell. When the target battery includes a plurality of cells, the plurality of cells can be connected in series and/or in parallel.

In an embodiment, average temperature during the target period of a target battery is obtained, which can include: cell temperature of each of the cells contained in the target battery during the target period is obtained; and the average value of the cell temperature is determined as the average temperature during the target period of the target battery.

In the embodiment, the cell temperature of each of the cells during the target period can be obtained according to thermal simulation.

The cycle in the embodiment is a charge/discharge cycle of the target battery. Then, the cycle time is the time of the charge and discharge cycle.

According to the embodiment, a predicted health state of the target battery is predicted according to the average value of the cell temperature of the cells in the target battery during the target period, and the prediction result can be made more accurate.

In step S2200, a cycle capacity loss of the target battery is determined according to the cycle time, the average temperature, and a first preset relationship; and a storage capacity loss of the target battery is determined according to the storage time, the average temperature, and a second preset relationship.

In the embodiment, the cycle capacity loss is a capacity loss of the target battery due to a charge-discharge cycle, and the storage capacity loss is a capacity loss of the target battery due to storage. The first preset relationship is a corresponding relationship between capacity losses of the battery due to the cycle time, the cycle temperature, and the charge/discharge cycle. The second preset relationship is a corresponding relationship between capacity losses of the battery due to the storage time, the storage temperature, and the storage.

In an embodiment, the first preset relationship can be expressed as:

$$Q1 = 1 - \left(c1 * T1^{d1} + e1\right) * t1^{f1}$$

wherein Q1 is the cycle capacity loss, T1 is the cycle temperature, t1 is the cycle time, and c1, d1, e1, f1 are the fitting coefficients.

In the embodiment, the average temperature can be the cycle temperature, and the cycle time and the cycle temperature can be substituted into the first preset relationship to obtain the cycle capacity loss.

In an embodiment, the second preset relationship can be expressed as:

$$Q2 = 1 - \left(c2 * T2^{d2} + e2\right) * t2^{f2}$$

wherein Q2 is the storage capacity loss, T2 is the storage temperature, t2 is the storage time, and c2, d2, e2 and f2 are the fitting coefficients.

In the embodiment, the average temperature can be the storage temperature, and the storage time and the storage temperature can be substituted into the second preset relationship to obtain the storage capacity loss.

In step S2300, a standard deviation of the cycle health state is obtained according to the cycle capacity loss and the third preset relationship; and a standard deviation of the storage health state is obtained according to the storage capacity loss and a fourth preset relationship.

In the embodiment, the third preset relationship is a corresponding relationship between the cycle health state and the standard deviation, and the fourth preset relationship is a corresponding relationship between the storage health state and the standard deviation.

The cycle health state can be the predicted health state of the target battery after the capacity loss caused by the cycle, specifically the difference between 1 and the cycle capacity loss; and the storage health state can be the predicted health state of the target battery after the capacity loss caused by the storage, specifically the difference between 1 and the storage capacity loss.

The standard deviation of the cycle health state corresponding to the cycle health state can be a distribution standard deviation indicating that the cells of the target battery have reached the cycle health state due to the manufacturing process. The standard deviation of the storage health state corresponding to the storage health state can be a distribution standard deviation indicating that the cells of the target battery have reached the storage health state due to the manufacturing process.

The State Of Health (SOH) of the battery can be the percentage of the battery's fully charged capacity relative to the rated capacity.

In an embodiment, the third preset relationship can be expressed as:

$$SD1 = A1 * \exp(SOH1^{B1} + C1) + D1$$

$$SOH1 = 1 - Q1$$

wherein SD1 is the standard deviation of the cycle health state, Q1 is the cycle capacity loss, SOH1 is the cycle health state, and A1, B1, C1 and D1 are the fitting coefficients.

In an embodiment, the fourth preset relationship can be expressed as:

$$SD2 = A2 * \exp(SOH2^{B2} + C2) + D2$$

$$SOH2 = 1 - Q2$$

wherein SD2 is the standard deviation of the storage health state, Q2 is the storage capacity loss, SOH2 is the storage health state, and A2, B2, C2, and D2 are the fitting coefficients.

In step S2400, a predicted health state of the target battery under the target operating condition is determined according to the cycle capacity loss, the storage capacity loss, the standard deviation of the cycle health state, and the standard deviation of the storage health state.

In an embodiment of the present disclosure, the predicted health state of the target battery is determined according to the cycle capacity loss, the storage capacity loss, the standard deviation of the cycle health state, and the standard deviation of the storage health state, which can include steps S2410 to S2430 as shown below:

in step S2410, the median value of the health state of a cell of the target battery under the target operating condition is obtained according to the cycle capacity loss and the storage capacity loss.

In the embodiment, the median value of the health state SOH3 can be expressed as:

$$SOH3 = 1 - Q1 - Q2$$

In step S2420, a distribution standard deviation of the health state of a cell of the target battery under the target operating condition is obtained according to the standard deviation of the cycle health state and the standard deviation of the storage health state.

The distribution standard deviation of health state can reflect the consistency deviation of health state of each cell in the target battery due to the manufacturing process.

In the embodiment, the standard deviation of the cycle health state and the standard deviation of the storage health state can be weighted and summed to obtain the distribution standard deviation of the health state.

In an example, the distribution standard deviation SD3 of the health state can be expressed as:

$$SD3 = SD1 * \lambda1 + SD2 * \lambda2$$

wherein SD1 is the standard deviation of the cycle health state, SD2 is the standard deviation of the storage health state, and $\lambda1$ and $\lambda2$ are preset weights.

In another example, the distribution standard deviation SD3 of the health state can be expressed as:

$$SD3 = SD1 * \frac{Q1}{Q1+Q2} + SD2 * \frac{Q2}{Q1+Q2}$$

wherein Q1 is the cycle capacity loss, Q2 is the storage capacity loss, SD1 is the standard deviation of the cycle health state, and SD2 is the standard deviation of the storage health state.

In step S2430, a predicted health state of the target battery is obtained according to the median value of the health state and the distribution standard deviation of the health state.

In an embodiment, the predicted health state of the target battery can be obtained according to the median value of the health state, the distribution standard deviation of the health state, and the fifth preset relationship.

The fifth preset relationship can be expressed as:

$$ SOH = SOH3 \pm n * SD3 $$

wherein SOH represents the predicted health state of the target battery, SOH3 is the median value of the health state, SD3 is the distribution standard deviation of the health state, and n is the number of standard deviations corresponding to the preset confidence interval.

The confidence interval can be set in advance according to the application scenario or specific needs. For example, the confidence interval can be 68%, 95%, or 99%.

n is the number of standard deviations corresponding to the confidence interval. For example, with a confidence interval of 68%, the corresponding number n of standard deviations can be 1. For another example, with a confidence interval of 95%, the corresponding number n of standard deviations can be 2. For another example, with a confidence interval of 99%, the corresponding number n of standard deviations can be 3.

According to the embodiment, the cycle capacity loss and the storage capacity loss of the target battery are determined according to the cycle time, the storage time and the average temperature of the target battery, then a standard deviation of the cycle health state and a standard deviation of the storage health state of the target battery are obtained according to the cycle capacity loss and the storage capacity loss, and the predicted health state of the target battery is predicted according to the cycle capacity loss, the storage capacity loss, the standard deviation of the cycle health state and the standard deviation of the storage health state. In the embodiment, from the perspective of cells, the consistency deviation of cycle and storage caused by the process for manufacturing cells is fully considered, and the predicted health state of the target battery can be more accurately predicted, and the calculation cost is low.

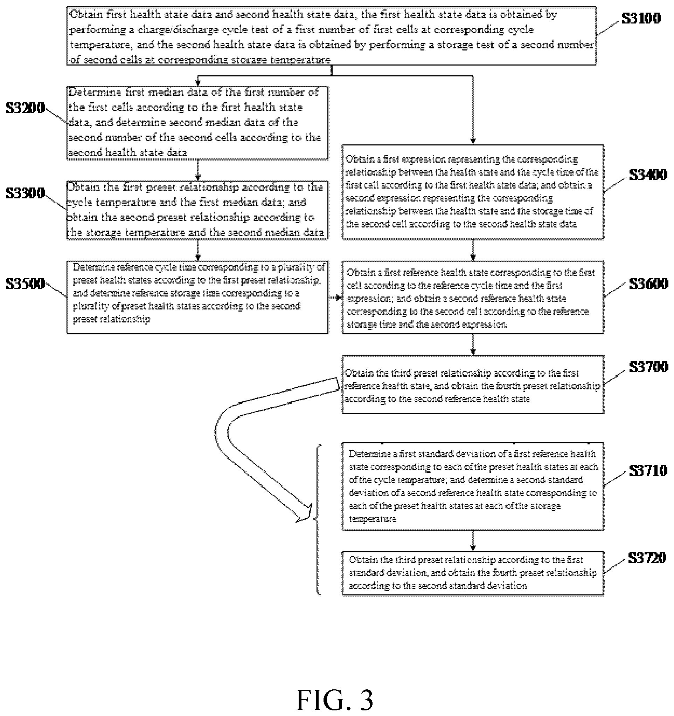

In an embodiment of the present disclosure, before executing step S2200, the method further includes steps S3100 to S3300 as shown in FIG. 3:

In step S3100, first health state data and second health state data are obtained, the first health state data is obtained by performing a charge/discharge cycle test of a first number of first cells at the corresponding cycle temperature, and the second health state data is obtained by performing a storage test of a second number of second cells at the corresponding storage temperature.

The first health state data refers to the data indicating the health state of the first cell after performing a charge/discharge cycle test for the preset cycle time, and the second health state data refers to the data indicating the health state of the second cell after performing a storage test for the preset storage time.

In the embodiment, the first cell and the second cell can be the same type of cell, and the production batches of any two cells of the first cell and the second cell can be the same or different. In an example, the first number of first cells and the second number of second cells can be all batches covering the model of cells.

Further, at least one cycle temperature and at least one storage temperature can be set in advance according to the application scenario or specific requirements. For example, the cycle temperature can include 25 °C, 35 °C, and 45 °C, and the storage temperature can include 25 °C, 45 °C, and 60 °C. Then, the first number of first cells can be divided into three parts in advance, and the first part of the first cells can be set in an environment of 25 °C to perform a charge/discharge cycle with a discharge depth of 100% and a charge/discharge current of 0.5 times; the second part of the first cells can be set in an environment of 35 °C to perform a charge/discharge cycle with a discharge depth of 100% and a charge/discharge current of 0.5 times; and the third part of the first cells can be set in an environment of 45 °C to perform a charge/discharge cycle with a discharge depth of 100% and a charge/discharge current of 0.5 times. The second number of second cells can be divided into three parts in advance, and the first part of the second cells can be set in an environment of 25 °C to perform a storage test with a State Of Charge (SOC) of 100%; the second part of the second cell can be set in an environment of 45 °C to perform a storage test with a state of charge of 100%; and the third part of the second cells can be set in an environment of 60 °C to perform a storage test with a state of charge of 100%.

When the charge/discharge cycle test is completed, the first health state data of each of the first cells can be obtained. When the storage test is completed, the second health state data of each of the second cells can be obtained.

The preset cycle time and the preset storage time in the embodiment can be a plurality of time set in advance according to an application scenario or a specific requirement, respectively. For example, the preset cycle time can include 1 day, 2 days, ..., 200 days, and the preset storage time can include 1 day, 2 days, ..., 300 days.

In step S3200, first median data of a first number of first cells is determined according to the first health state data, and second median data of a second number of second cells is determined according to the second health state data. The first median data refers to the data indicating an average value of the health state of the first number of first cells after performing a charge/discharge cycle test for the preset cycle time, and the second median data refers to the data indicating an average value of the health state of the second number of second cells after performing a storage test for the preset storage time.

In the embodiment, for each of the preset cycle time, an average value of the health state of the first number of first cells after performing the charge/discharge cycle test for the preset cycle time is determined to obtain first median data; and for each of the preset storage time, an average value of the health state of the second number of second cells after performing the storage test for the storage time is determined to obtain second median data.

In step S3300, a first preset relationship is obtained according to the cycle temperature and the first median data; and a second preset relationship is obtained according to the storage temperature and the second median data.

In the embodiment, the initial form of the first preset relationship is established according to the first median data:

$$Q1 = 1 - g1 * t1^{f1}$$

wherein g1 is a first fitting coefficient.

The initial form of the second preset relationship is established according to the second median data:

$$Q2 = 1 - g2 * t2^{f2}$$

wherein g2 is a second fitting coefficient.

First fitting coefficients are different at different cycle temperatures, and second fitting coefficients are different at different storage temperatures.

Therefore, a third expression representing the corresponding relationship between the first fitting coefficient g1 and the cycle temperature T1 can be established according to the first health state data of each of the first cells and the corresponding cycle temperature, and a fourth expression representing the corresponding relationship between the second fitting coefficient g2 and the storage temperature T2 can be established according to the second health state data of each of the second cells and the corresponding storage temperature.

The third expression in the embodiment can be expressed as:

$$g1 = c1 * T1^{d1} + e1$$

The fourth expression in the embodiment can be expressed as:

$$g2 = c2 * T2^{d2} + e2$$

When predicting the predicted health state of the target battery, according to the first preset relationship and the second preset relationship constructed in the embodiment, the median value of the cycle capacity loss of the target battery due to the charge-discharge cycle and the median value of the storage capacity loss of the target battery due to storage can be determined, and further the median value of the predicted health state of the target battery is determined according to the median value of the cycle capacity loss and the median value of the storage capacity loss.

In an embodiment of the present disclosure, before executing step S2200, the method further includes steps S3400 to S3700 as shown in FIG. 3:

in step S3400, a first expression representing the corresponding relationship between the health state and the cycle time of the first cell is obtained according to the first health state data; and a second expression representing the corresponding relationship between the health state and the storage time of the second cell is obtained according to the second health state data.

In the embodiment, the first expression of the first cell can be obtained according to the first health state data of each of the first cells. The first expression can be expressed as:

$$SOH1 = a1 * t1^{b1}$$

wherein SOH1 is the health state of the first cell, t1 is the cycle time, and a1 and b1 are fitting coefficients.

In the embodiment, the second expression of the second cell can be obtained according to the second health state data of each of the second cells. The second expression can be expressed as:

$$SOH2 = a2 * t2^{b2}$$

wherein SOH2 is the health state of the first cell, t2 is the storage time, and a2 and b2 are fitting coefficients.

In step S3500, reference cycle time corresponding to a plurality of preset health states is determined according to the first preset relationship, and reference storage time corresponding to a plurality of preset health states is determined according to the second preset relationship.

The preset health states in the embodiment can be set in advance according to an application scenario or a specific requirement. For example, the preset health states can include 95%, 90%, 85%, 80%, 75%, 70%, 65%, and 60%.

Each of the preset health states can be substituted into the first preset relationship respectively, to obtain the reference cycle time corresponding to each of the preset health states. Each of the preset health states can be substituted into the second preset relationship, respectively, to obtain the reference cycle time corresponding to each of the preset health states.

In step S3600, a first reference health state corresponding to the first cell is obtained according to the reference cycle time and the first expression; and a second reference health state corresponding to the second cell is obtained according to the reference storage time and the second expression.

In the embodiment, each of the reference cycle time can be substituted into the first expression of each of the first cells respectively, and the first reference health state of each of the first cells after the charge/discharge cycle test for each of the reference cycle time can be obtained. Each of the reference storage time can be substituted into the second expression of each of the second cells respectively, and the second reference health state of each of the second cells after the storage test for each of the reference storage time can be obtained.

In step S3700, a third preset relationship is obtained according to the first reference health state, and a fourth preset relationship is obtained according to the second reference health state.

In the embodiment, the reference cycle time and the reference storage time corresponding to the preset health state is obtained according to the first preset relationship and the second preset relationship, then the first reference health state corresponding to the first cell is obtained according to the reference cycle time and the first expression, and the second reference health state corresponding to the second cell is obtained according to the reference storage time and the second expression, so as to fit the third preset relationship according to the first reference health state and fit the fourth preset relationship according to the second reference health state, thereby shortening the test time of the first cell and the second cell and reducing the test cost.

In an embodiment of the present disclosure, a third preset relationship is obtained according to the first reference health state, and a fourth preset relationship is obtained according to the second reference health state, which can include steps S3710 to S3720 as shown in FIG. 3:

In step S3710, a first standard deviation of a first reference health state corresponding to each of the preset health states at each of the cycle temperatures is determined; and a second standard deviation of a second reference health state corresponding to each of the preset health states at each of the storage temperatures is determined.

In the embodiment, the first reference health states of the first number of first cells can be grouped according to the preset health state and the cycle temperature, and when the number of preset health states is 8 and the cycle temperature is 3, 8 * 3 = 24 groups of first reference health states can be obtained, and each group of first reference health states can be determined by the reference cycle time corresponding to the same preset health state, and the cycle temperature corresponding to the first cells is the same.

Further, the standard deviation of each group of first reference health states can be determined as the first standard deviation.

In the embodiment, the second reference health states of the second number of second cells can be grouped according to the preset health state and the cycle temperature, and when the number of preset health states is 8 and the storage temperature is 3, 8 * 3 = 24 groups of second reference health states can be obtained, and each group of second reference health states can be determined by the reference cycle time corresponding to the same preset health state, and the storage temperature corresponding to the second cells is the same.

Further, the standard deviation of each group of second reference health states can be determined as the second standard deviation.

In step S3720, a third preset relationship is obtained according to the first standard deviation, and a fourth preset relationship is obtained according to the second standard deviation.

In the embodiment, a third preset relationship representing the corresponding relationship between the cycle health state and the standard deviation can be obtained according to the standard deviation of each group of the first reference health state and the corresponding preset health state. A fourth preset relationship representing the corresponding relationship between the storage health state and the standard deviation can be obtained according to the standard deviation of each group of the second reference health state and the corresponding preset health state.

When predicting the predicted health state of the target battery, according to the third preset relationship and the fourth preset relationship constructed in the embodiment, the consistency deviation of the target battery in reaching the cycle health state due to the manufacturing process and the consistency deviation of the target battery in reaching the storage health state due to the manufacturing process can be determined, furthermore, according to the consistency deviation of the target battery in reaching the cycle health state due to the manufacturing process and the consistency deviation of the target battery in reaching the storage health state due to the manufacturing process, the consistency deviation of the target battery in reaching the health state due to the manufacturing process is determined.

In another embodiment of the present disclosure, a third preset relationship is obtained according to the first standard deviation and a fourth preset relationship is obtained according to the second standard deviation, which can further include: a standard deviation of a first reference health state corresponding to each of the preset health states and a standard deviation of a second reference health state corresponding to each of the preset health states are determined; and a third preset relationship is obtained according to the standard deviation of the first reference health state corresponding to each of the preset health states, and a fourth preset relationship is obtained according to the standard deviation of the second reference health state corresponding to each of the preset health states.

< Device Embodiment >

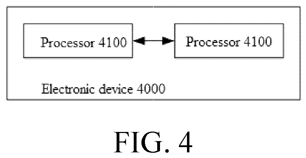

FIG. 4 is a schematic structural diagram of a hardware structure of an electronic device according to another embodiment.

As shown in FIG. 4, the electronic device 4000 includes a processor 4100 and a memory 4200, the memory 4200 is configured to store an executable computer program, and the processor 4100 is configured to perform a method as in any of the above method embodiments according to the control of the computer program.

The electronic device 4000 can be an electronic product such as a smartphone, a portable computer, a desktop computer, a tablet computer, a server, or a computer cluster.

Each module of the above-described electronic device 4000 can be realized by the processor 4100 in the embodiment executing a computer program stored in the memory 4200, or can be realized by other circuit configurations, which are not limited herein.

< Computer - Readable Storage Medium Embodiment >

The embodiment provides a computer-readable storage medium, the storage medium is configured to store an executable command, when executed by the processor, the executable command executes the method describe in any method embodiment of the present specification.

The present invention can be a system, method, and/or computer program product. The computer program product can include a computer-readable storage medium on which computer-readable program instructions are loaded for causing a processor to implement various aspects of the present invention.

A computer-readable storage medium can be a tangible device that can hold and store instructions used by an instruction execution device. The computer-readable storage medium can be, for example, but is not limited to, an electrical storage device, a magnetic storage device, an optical storage device, an electromagnetic storage device, a semiconductor storage device, or any suitable combination thereof. More specific examples (a non-exhaustive list) of computer-readable storage media include portable computer disks, hard disks, random access memory (RAM), read-only memory (ROM), erasable programmable read-only memory (EPROM or flash memory), static random access memory (SRAM), portable compact disk read-only memory (CD-ROM), digital versatile disks (DVDs), memory sticks, floppy disks, mechanical encoding devices, such as punch cards or in-groove raised structures having instructions stored thereon, and any suitable combination thereof. The computer-readable storage medium used herein should not be interpreted as a transient signal itself, such as radio waves or other freely propagating electromagnetic waves, electromagnetic waves propagating through waveguides or other transmission media (e.g., light pulses through fiber optic cables), or electrical signals transmitted through electrical wires.

The computer-readable program instructions described herein can be downloaded from a computer-readable storage medium to various computing/processing devices, or to an external computer or external storage device over a network, such as the Internet, a local area network, a wide area network, and/or a wireless network. The network can include copper transmission cables, fiber optic transmissions, wireless transmissions, routers, firewalls, switches, gateway computers, and/or edge servers. A network adapter card or network interface in each computing/processing device receives computer-readable program instructions from a network and forwards the computer-readable program instructions for storage in a computer-readable storage medium in the respective computing/processing device.

The computer program instructions for performing the operations of the present invention can be assembly instructions, instruction set architecture (ISA) instructions, machine instructions, machine-related instructions, microcode, firmware instructions, state setting data, or source code or object code written in any combination of one or more programming languages, and the programming languages include obj ect-oriented programming languages such as Smalltalk, C + +, etc., and conventional procedural programming languages such as the "C" language or similar programming languages. The computer-readable program instructions can be executed entirely on the user's computer, partially on the user's computer, as a standalone software package, partially on the user's computer and partially on a remote computer, or entirely on a remote computer or server. In cases involving a remote computer, the remote computer can be connected to the user computer through any kind of network, including a local area network (LAN) or a wide area network (WAN), or can be connected to an external computer (e.g., using an Internet service provider to connect over the Internet). In some embodiments, an electronic circuit, such as a programmable logic circuit, a field programmable gate array (FPGA), or a programmable logic array (PLA), is personalized by utilizing state information of computer readable program instructions. The electronic circuit can execute computer readable program instructions to implement various aspects of the present invention.

Various aspects of the invention are described herein with reference to flowcharts and/or block diagrams of methods, apparatus (systems) and computer program products according to embodiments of the invention. It should be understood that each block of the flowchart and/or block diagrams, and combinations of blocks in the flowchart and/or block diagrams, can be implemented by computer-readable program instructions.

These computer-readable program instructions can be provided to a processor of a general-purpose computer, special-purpose computer, or other programmable data processing apparatus, thereby producing a machine such that, when executed by the processor of the computer or other programmable data processing apparatus, the instructions produce apparatus for implementing the functions/acts specified in one or more blocks in the flowchart and/or block diagram. Such computer-readable program instructions can also be stored in a computer-readable storage medium that cause the computer, programmable data processing apparatus, and/or other apparatus to operate in a particular manner, such that the computer-readable medium storing the instructions comprises an article of manufacture comprising instructions that implement various aspects of the functions/acts specified in one or more blocks in the flowchart and/or block diagram.

Computer-readable program instructions can also be loaded onto a computer, other programmable data processing apparatus, or other apparatus such that a series of operational steps are performed on the computer, other programmable data processing apparatus, or other apparatus to produce a computer-implemented process such that the instructions executed on the computer, other programmable data processing apparatus, or other apparatus implement the functions/acts specified in one or more blocks in the flowchart and/or block diagram.

The flowcharts and block diagrams in the drawings illustrate the architecture, functionality, and operation of possible implementations of systems, methods, and computer program products according to various embodiments of the present invention. In this regard, each block in the flowchart or block diagram can represent a module, program segment, or portion of instructions, and the module, program segment, or portion of instructions include one or more executable instructions for implementing a specified logical function. In some alternative implementations, the functions noted in the blocks can also occur in a different order than that noted in the drawings. For example, two consecutive blocks can actually be executed substantially in parallel, and they can sometimes be executed in reverse order, depending on the function involved. It is also noted that each block in the block diagrams and/or flowchart diagrams, and combinations of blocks in the block diagrams and/or flowchart diagrams, can be implemented with a dedicated hardware-based system that performs the specified functions or acts, or can be implemented with a combination of dedicated hardware and computer instructions. It is well known to a person skilled in the art that implementations by hardware, implementations by software, and implementations by combinations of software and hardware are equivalent.

Although various embodiments of the present invention have been described above, the above description is exemplary, not exhaustive, and is not limited to the disclosed embodiments. Many modifications and alterations will be apparent to a person skill in the art without departing from the scope and spirit of the illustrated embodiments. The terminology used herein is chosen to best explain the principles, practical applications, or technical improvements in the market of the various embodiments, or to enable a person skill in the art to understand the various embodiments disclosed herein. The scope of the invention is defined by the appended claims.

**Claims**

1. A method for predicting a battery health state, comprising:

obtaining cycle time, storage time, and average temperature during a target period of a target battery according to a preset target operating condition;

determining a cycle capacity loss of the target battery according to the cycle time, the average temperature, and a first preset relationship; and determining a storage capacity loss of the target battery according to the storage time, the average temperature, and a second preset relationship;

obtaining a standard deviation of the cycle health state according to the cycle capacity loss and a third preset relationship; and obtaining a standard deviation of the storage health state according to the storage capacity loss and a fourth preset relationship;

and determining a predicted health state of the target battery under the target operating condition according to the cycle capacity loss, the storage capacity loss, the standard deviation of the cycle health state, and the standard deviation of the storage health state.

2. The method according to claim 1, wherein determining the predicted health state of the target battery under the target operating condition according to the cycle capacity loss, the storage capacity loss, the standard deviation of the cycle health state, and the standard deviation of the storage health state comprises:

obtaining a median value of the health state of a cell of the target battery under the target operating condition according to the cycle capacity loss and the storage capacity loss;

obtaining a distribution standard deviation of the health state of a cell of the target battery under the target operating condition according to the standard deviation of the cycle health state and the standard deviation of the storage health state;

and obtaining a predicted health state of the target battery according to the median value of the health state and the distribution standard deviation of the health state.

3. The method according to claim 1 or 2, wherein the method further comprises:

the first health state data being obtained by performing a charge/discharge cycle test of a first number of first cells at corresponding cycle temperature, and the second health state data being obtained by performing a storage test of a second number of second cells at corresponding storage temperature; and the first health state data referring to the data indicating the health state of the first cell after performing a charge/discharge cycle test for the preset cycle time, and the second health state data referring to the data indicating the health state of the second cell after performing a storage test for the preset storage time;

determining first median data of the first number of the first cells according to the first health state data, and determining second median data of the second number of the second cells according to the second health state data, the first median data referring to the data indicating an average value of the health state of the first number of the first cells after performing a charge/discharge cycle test for the preset cycle time, and the second median data referring to the data indicating an average value of the health state of the second number of the second cells after performing a storage test for the preset storage time;

and obtaining the first preset relationship according to the cycle temperature and the first median data; and obtaining the second preset relationship according to the storage temperature and the second median data.

4. The method according to claim 3, wherein the method further comprises:

obtaining a first expression representing the corresponding relationship between the health state and the cycle time of the first cell according to the first health state data; and obtaining a second expression representing the corresponding relationship between the health state and the storage time of the second cell according to the second health state data;

determining reference cycle time corresponding to a plurality of preset health states according to the first preset relationship, and determining reference storage time corresponding to a plurality of preset health states according to the second preset relationship;

obtaining a first reference health state corresponding to the first cell according to the reference cycle time and the first expression; and obtaining a second reference health state corresponding to the second cell according to the reference storage time and the second expression;

and obtaining the third preset relationship according to the first reference health state, and obtaining the fourth preset relationship according to the second reference health state.

5. The method according to claim 4, wherein obtaining the third preset relationship according to the first reference health state, and obtaining the fourth preset relationship according to the second reference health state comprises:

determining a first standard deviation of a first reference health state corresponding to each of the preset health states at each of the cycle temperature; and determining a second standard deviation of a second reference health state corresponding to each of the preset health states at each of the storage temperature;
and obtaining the third preset relationship according to the first standard deviation, and obtaining the fourth preset relationship according to the second standard deviation.

6. The method according to any one of claims 1 to 4, wherein the first preset relationship is:

$$Q1 = 1 - \left(c1 * T1^{d1} + e1\right) * t1^{f1}$$

wherein Q1 is the cycle capacity loss, T1 is the cycle temperature, t1 is the cycle time, and c1, d1, e1, f1 are the fitting coefficients;
the second preset relationship is:

$$Q2 = 1 - \left(c2 * T2^{d2} + e2\right) * t2^{f2}$$

wherein Q2 is the storage capacity loss, T2 is the storage temperature, t2 is the storage time, and c2, d2, e2 and f2 are the fitting coefficients.

7. The method according to any one of claims 1 to 6, wherein the third preset relationship is:

$$SD1 = A1 * \exp(SOH1^{B1} + C1) + D1$$

$$SOH1 = 1 - Q1$$

wherein SD1 is the standard deviation of the cycle health state, Q1 is the cycle capacity loss, and A1, B1, C1 and D1 are the fitting coefficients;
the fourth preset relationship is:

$$SD2 = A2 * \exp(SOH2^{B2} + C2) + D2$$

$$SOH2 = 1 - Q2$$

wherein SD2 is the standard deviation of the storage health state, Q2 is the storage capacity loss, and A2, B2, C2, and D2 are the fitting coefficients.

8. The method according to any one of claims 1 to 7, wherein obtaining the average temperature during the target period of the target battery comprises:

obtaining cell temperature of each of the cells contained in the target battery during the target period;
and determining the average value of the cell temperature as the average temperature.

9. An electronic device, comprising a memory and a processor, the memory being configured to store a computer program, and the processor being configured to execute the method according to any one of claims 1 to 8 under the control of the computer program.

10. A computer-readable storage medium, storing a computer program thereon and when executed by a processor, the computer program implements the method according to any one of claims 1 to 8.

FIG. 1

| Obtain cycle time, storage time, and average temperature during the target period of a target battery according to a preset target operating condition | S2100 |

| Determine a cycle capacity loss of the target battery according to the cycle time, the average temperature, and a first preset relationship; and determine a storage capacity loss of the target battery according to the storage time, the average temperature, and a second preset relationship | S2200 |

| Obtain a standard deviation of the cycle health state according to the cycle capacity loss and a third preset relationship; and obtain a standard deviation of the storage health state according to the storage capacity loss and a fourth preset relationship | S2300 |

| Determine a predicted health state of the target battery under the target operating condition according to the cycle capacity loss, the storage capacity loss, the standard deviation of the cycle health state, and the standard deviation of the storage health state | S2400 |

FIG. 2

Obtain first health state data and second health state data, the first health state data is obtained by performing a charge/discharge cycle test of a first number of first cells at corresponding cycle temperature, and the second health state data is obtained by performing a storage test of a second number of second cells at corresponding storage temperature — S3100

Determine first median data of the first number of the first cells according to the first health state data, and determine second median data of the second number of the second cells according to the second health state data — S3200

Obtain the first preset relationship according to the cycle temperature and the first median data; and obtain the second preset relationship according to the storage temperature and the second median data — S3300

Obtain a first expression representing the corresponding relationship between the health state and the cycle time of the first cell according to the first health state data; and obtain a second expression representing the corresponding relationship between the health state and the storage time of the second cell according to the second health state data — S3400

Determine reference cycle time corresponding to a plurality of preset health states according to the first preset relationship, and determine reference storage time corresponding to a plurality of preset health states according to the second preset relationship — S3500

Obtain a first reference health state corresponding to the first cell according to the reference cycle time and the first expression; and obtain a second reference health state corresponding to the second cell according to the reference storage time and the second expression — S3600

Obtain the third preset relationship according to the first reference health state, and obtain the fourth preset relationship according to the second reference health state — S3700

Determine a first standard deviation of a first reference health state corresponding to each of the preset health states at each of the cycle temperature; and determine a second standard deviation of a second reference health state corresponding to each of the preset health states at each of the storage temperature — S3710

Obtain the third preset relationship according to the first standard deviation, and obtain the fourth preset relationship according to the second standard deviation — S3720

FIG. 3

Processor 4100 ◄──► Processor 4100

Electronic device 4000

FIG. 4

## INTERNATIONAL SEARCH REPORT

| International application No. |
| --- |
| **PCT/CN2023/102163** |

### A. CLASSIFICATION OF SUBJECT MATTER

G01R31/36(2020.01)i

According to International Patent Classification (IPC) or to both national classification and IPC

### B. FIELDS SEARCHED

Minimum documentation searched (classification system followed by classification symbols)

IPC:G01R31

Documentation searched other than minimum documentation to the extent that such documents are included in the fields searched

Electronic data base consulted during the international search (name of data base and, where practicable, search terms used)

CNTXT, CNKI, ENTXTC, DWPI, VEN: 电池, 健康状态, 预测, 循环, 运行, 运营, 工作, 存储, 搁置, 待机, 温度, 容量损失, 容量损耗, 容量衰减, 标准差, 中值, 均值, health state, SOH, cell, battery, predict, forecast, circulation, cycle, storage, temperature, capacity attenuation, standard deviation, mean, average

### C. DOCUMENTS CONSIDERED TO BE RELEVANT

| Category* | Citation of document, with indication, where appropriate, of the relevant passages | Relevant to claim No. |
| --- | --- | --- |
| Y | CN 114217235 A (NEUSOFT REACH AUTOMOTIVE TECHNOLOGY (SHENYANG) CO., LTD.) 22 March 2022 (2022-03-22) description, paragraphs 0006-0074 | 1-10 |
| Y | CN 112034350 A (XIAMEN KECAN INFORMATION TECHNOLOGY CO., LTD. et al.) 04 December 2020 (2020-12-04) description, paragraphs 0005-0090 | 1-10 |
| Y | CN 115099008 A (CHINA THREE GORGES CORP. et al.) 23 September 2022 (2022-09-23) description, paragraphs 0006-0083 | 1-10 |
| Y | CN 114325444 A (ZHEJIANG LEAPMOTOR TECHNOLOGY CO., LTD.) 12 April 2022 (2022-04-12) description, paragraphs 0021-0027 | 1-10 |
| Y | CN 114035087 A (CHINA ELECTRIC POWER RESEARCH INSTITUTE et al.) 11 February 2022 (2022-02-11) description, paragraphs 0010-0164 | 1-10 |

☑ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **13 October 2023** | **18 October 2023** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
|---|
| **PCT/CN2023/102163** |

**C.    DOCUMENTS CONSIDERED TO BE RELEVANT**

| Category* | Citation of document, with indication, where appropriate, of the relevant passages | Relevant to claim No. |
|---|---|---|
| Y | CN 113406523 A (CHINA ELECTRIC POWER RESEARCH INSTITUTE CO., LTD.) 17 September 2021 (2021-09-17) description, paragraphs 0008-0056 | 1-10 |
| Y | CN 115184830 A (CHUNENG NEW ENERGY CO., LTD.) 14 October 2022 (2022-10-14) description, paragraphs 0005-0062 | 1-10 |
| Y | CN 110261790 A (BEIJING HYPERSTRONG TECHNOLOGY CO., LTD.) 20 September 2019 (2019-09-20) description, paragraphs 0006-0102, and figure 2 | 1-10 |
| Y | CN 105974326 A (SINOEV (HEFEI) TECHNOLOGIES CO., LTD.) 28 September 2016 (2016-09-28) description, paragraphs 0008-0131 | 1-10 |
| Y | WO 2021143482 A1 (ZHENGZHOU YUTONG BUS CO., LTD.) 22 July 2021 (2021-07-22) description, paragraphs 0006-0076 | 1-10 |
| Y | CN 115128494 A (CHINA ENERGY INVESTMENT CORP., LTD. et al.) 30 September 2022 (2022-09-30) description, paragraphs 0004-0077, and figure 1 | 1-10 |
| A | CN 114814630 A (SHENZHEN PANDPOWER CO., LTD.) 29 July 2022 (2022-07-29) entire document | 1-10 |
| A | CN 114720900 A (NEUSOFT REACH AUTOMOTIVE TECHNOLOGY (SHENYANG) CO., LTD) 08 July 2022 (2022-07-08) entire document | 1-10 |

Form PCT/ISA/210 (second sheet) (July 2022)

**INTERNATIONAL SEARCH REPORT**
Information on patent family members

| International application No. |
|---|
| **PCT/CN2023/102163** |

| Patent document cited in search report | | | Publication date (day/month/year) | Patent family member(s) | | | Publication date (day/month/year) |
|---|---|---|---|---|---|---|---|
| CN | 114217235 | A | 22 March 2022 | None | | | |
| CN | 112034350 | A | 04 December 2020 | None | | | |
| CN | 115099008 | A | 23 September 2022 | None | | | |
| CN | 114325444 | A | 12 April 2022 | None | | | |
| CN | 114035087 | A | 11 February 2022 | None | | | |
| CN | 113406523 | A | 17 September 2021 | None | | | |
| CN | 115184830 | A | 14 October 2022 | None | | | |
| CN | 110261790 | A | 20 September 2019 | None | | | |
| CN | 105974326 | A | 28 September 2016 | None | | | |
| WO | 2021143482 | A1 | 22 July 2021 | EP | 4083643 | A1 | 02 November 2022 |
| | | | | EP | 4083643 | A4 | 21 June 2023 |
| CN | 115128494 | A | 30 September 2022 | None | | | |
| CN | 114814630 | A | 29 July 2022 | None | | | |
| CN | 114720900 | A | 08 July 2022 | None | | | |

Form PCT/ISA/210 (patent family annex) (July 2022)

**REFERENCES CITED IN THE DESCRIPTION**

**Patent documents cited in the description**

- CN 202211348958